(19) Europäisches Patentamt
European Patent Office
Office européen des brevets

(11) Veröffentlichungsnummer: **0 280 085 B1**

(12) # EUROPÄISCHE PATENTSCHRIFT

(45) Veröffentlichungstag der Patentschrift: **31.07.91**

(51) Int. Cl.5: **C09D 183/04**, C08L 83/04, H01L 21/312, G02F 1/133, G03F 7/00

(21) Anmeldenummer: **88101586.1**

(22) Anmeldetag: **04.02.88**

(54) **Beschichtungslösung und Verfahren zur Erzeugung glasartiger Schichten.**

(30) Priorität: **13.02.87 DE 3704518**

(43) Veröffentlichungstag der Anmeldung:
**31.08.88 Patentblatt 88/35**

(45) Bekanntmachung des Hinweises auf die Patenterteilung:
**31.07.91 Patentblatt 91/31**

(84) Benannte Vertragsstaaten:
**AT BE CH DE FR GB IT LI NL SE**

(56) Entgegenhaltungen:
**DE-A- 3 537 626**
**US-A- 2 917 467**

**Beschichtungslösungen - Anmelder: Merck Patent, Darmstadt**

(73) Patentinhaber: **HOECHST AKTIENGESELLSCHAFT**
**Postfach 80 03 20**
**W-6230 Frankfurt am Main 80(DE)**

(72) Erfinder: **Merrem, Hans-Joachim, Dr.**
**Donnersbergstrasse 6**
**W-6104 Seeheim-Jugenheim(DE)**
Erfinder: **Graf, Werner, Dr.**
**Ludwig-Thoma-Strasse 21**
**W-8263 Burghausen(DE)**

EP 0 280 085 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung beschreibt eine Beschichtungslösung zur Erzeugung glasartiger Schichten auf einem Substrat sowie ein Verfahren zur Herstellung von Beschichtungen.

Verfahren zur Erzeugung glasartiger Schichten aus Lösungen von Polyorganosiloxanen sind seit langem bekannt. Wenn diese Lösungen einen oder mehrere Dotierstoffe enthalten, wie z.B. Elemente der III. und V. Gruppe des Periodensystems, die üblicherweise als freie Säuren, als Oxidhydrate, als Alkoxide oder als Oxide eingesetzt werden, können die daraus hergestellten glasartigen Schichten zum Dotieren von Halbleitersubstraten eingesetzt werden.

Dagegen werden glasartige Schichten ohne Dotierstoffe als Getterschichten zum Entfernen unerwünschter Verunreinigungen von Halbleitersubstraten verwendet. Andererseits werden sie auch als Isolationsschichten beispielsweise in der Halbleitertechnologie oder bei der Herstellung von Flüssigkristalldisplays benutzt. Daneben ist ebenfalls bekannt, sie als Planarisierungsschichten bei der Herstellung von Halbleiterbauelementen und als plasmaätzresistente Zwischenschichten in Mehrlagensystemen zur Erzeugung hochaufgelöster Strukturen zu verwenden.

Bei allen Anwendungen ist für eine gleichmäßige Schichtdicke Sorge zu tragen, denn eine ungleichmäßige Schichtdicke kann zu erheblichen Störungen der Isolations- und Abdeckfunktionen der Schicht führen.

Soll eine ungleichmäßige Schicht geätzt werden, so können unerwünschte Schwankungen in der Dimensionstreue der Strukturübertragung auftreten. Im Falle von Plasmaätzverfahren wird das unter der Schicht liegende Substrat unterschiedlich stark angegriffen, so daß die Schichtdickenschwankungen auf das Substrat übertragen werden können.

Wird eine mit einer herkömmlichen Beschichtungslösung erzeugte glasartige Schicht mit einer Photoresistschicht überzogen, so kann eine Ungleichmäßigkeit der glasartigen Schicht (spin-on Glasschicht) bei Belichtung der Resistschicht mit monochromatischem Licht im Projektionsverfahren zu Belichtungsschwankungen und daher zu Belichtungsfehlern im Resist führen, weil die in der dünnen glasartigen Schicht entstehenden Interferenzen aufgrund ihrer unterschiedlichen Dicke zu Reflexionsunterschieden führen.

Dient die spin-on Glasschicht als Diffusionsquelle für Dotiermaterial, so kann es aufgrund unterschiedlicher Dicken dieser Schicht zu Schwankungen in der Dotierung des Halbleitermaterials kommen.

Die in diesen Schichten enthaltenen Polyorganosiloxane können auf unterschiedliche Weise - entsprechend der jeweils unterschiedlichen Beschichtungslösung - hergestellt werden.

In der US-A-3,615,943 werden Beschichtungslösungen beschrieben, die Umsetzungsprodukte aus Siliciumtetrachlorid und Essigsäureanhydrid enthalten. Der Nachteil dieser Produkte ist zum einen die aufwendige Herstellung aus den genannten Edukten, zum anderen die zur Herstellung einer Glasschicht erforderliche hohe Temperatur von mindestens 225° C. Angaben zur Stabilität der Beschichtungslösung und über die Gleichmäßigkeit der Oberfläche der resultierenden Schicht werden nicht gemacht. Die Schicht kann u.U. Dotiermaterial der Elemente B, P, As, Sb, Cd, In, Ga und Al enthalten.

Umsetzungsprodukte, die in Ethanol aus Tetraethylorthosilikat mit Essigsäureanhydrid und einem Dotiermaterial der Elemente B, P, As, Au und Zn als glasbildende Komponente entstehen, werden in den US-A-3,837,873 und 3,915,766 beschrieben. Zur Gleichmäßigkeit der Beschichtung sind keine Angaben gemacht.

In der US-A-4,152,286 wird wiederum eine Beschichtungslösung beschrieben, in der Tetraethylorthosilikat mit Essigsäureanhydrid reagiert, allerdings in einem Lösungsmittelgemisch aus Ethoxyethanol und Diethylphthalat. Es wird ausgeführt, daß durch die Wahl dieses Lösungsmittelgemischs eine Präzipitatbildung (Auskristallisierung von $B_2O_3$ als Dotierstoff) kurz nach dem "spin-on" Schritt, im Gegensatz zu den Lösungen aus den US-A-3,837,873 und 3,915,766, vermieden werden kann. Eine Angabe über Lagerstabilität und Schichtqualität wird nicht gemacht.

Da in allen bisher diskutierten Dokumenten der Gehalt an hochsiedendem Essigsäureanhydrid sehr hoch ist, ist das Ausheizen bei hohen Temperaturen unumgänglich.

Besonders gleichmäßige Schichten auf Halbleitersubstraten soll man nach der DE-A 23 40 111 (= US-A-3,789,023) erhalten. Zur Viskositätseinstellung dotierstoffhaltiger Tetraethylorthosilikatlösungen in Ethanol und Ethylacetat werden ca. 3 % Glycerin hinzugegeben. Höhere Alkohole als Ethanol als Lösungsmittel werden nicht genannt. Eine Angabe zur Lagerstabilität der Beschichtungslösung fehlt.

Eine weitere Verbesserung der Oberflächengleichmäßigkeit wird nach der DE-A 2 338 079 (= US-A-3,832,202) durch Gemische aus mit Ethanol umgesetzten Vinyltrichlorsilan und Tetraethylorthosilikat gelöst in wäßrigem Ethanol, dem Glycerin zugefügt wurde, erhalten. Diese Version ist jedoch nur als Zweikomponentensystem beschrieben, d.h. nicht lagerstabil.

Beschichtungslösungen zum Dotieren von Halbleitersubstraten werden in den DE-A 24 47 204, 25 30 574, 29 20 673, 29 52 116 und 30 30 298 beschrieben. Sie bestehen aus einer Lösung von Tetraalkylorthosilikat, vorzugsweise Tetraethylorthosilikat und einer wäßrigen Lösung eines Dotierstoffes in einem Alkohol, vorzugsweise Methanol oder 2-Propanol. Ferner können, wie in der DE-A 29 20 673 beschrieben, höher siedende Komponenten, wie Polypropylenglykol, zugesetzt werden. Angaben über die Haltbarkeit der Lösungen werden nicht gemacht; es werden auch keine höheren Alkohole als Lösungsmittel genannt.

In der US-A-3,928,225 wird eine borhaltige Dotierlösung, enthaltend ein Tetraethylorthosilikat, ein Metallsalz (Ni, Pb, Ca, Sn), eine organischen Säure in Ethanol und Ethylenglykolmonomethylether oder Ethylenglykol beschrieben, in der durch Zugabe von Milchsäure die Polymerisationstemperatur des Kieselsäureesters reduziert werden kann. Es werden keine Angaben bezüglich Haltbarkeit und Schichtqualität gemacht.

Eine mit Phosphor hochdotierte Lösung wird in der US-A-4,243,427 genannt. Diese Lösung wird jedoch als Zweikomponentensystem beschrieben, bestehend aus einer Tetraethylorthosilikatlösung in Methanol und einer wäßrig-methanolischen Phosphorsäure (als $Al(H_2PO_4)_3$), wobei die beiden Komponenten zur Ausbildung einer Beschichtung gemischt und sofort - wegen dessen Instabilität - verarbeitet werden muß.

Aus der DE-A 29 22 900 geht hervor, daß die bisherigen bekannten Beschichtungen Schichtdickenunterschiede (sogenannte "striations") aufweisen können. Die in dieser Offenlegungsschrift beschriebene Tetraethylorthosilikatlösung in Aceton wird durch Zusatz von Salpetersäure polymerisiert. Durch Zugabe von Siliconöl sollen die "striations" beseitigt werden können. Die Beschichtungslösung ist als Zweikomponentensystem beschrieben, was auf geringe Haltbarkeit der gebrauchsfertigen Lösung schließen läßt.

Eine Beschichtungslösung, die neben Poly(ethoxysiloxan) oder Poly(methoxysiloxan) auch ein Präpolymer, Poly(silsesquioxan), enthält, wird in der EP-A-0 112 168 beschrieben. In diesem Fall soll die Gleichmäßigkeit der Beschichtung durch die Kombination beider Polymere erreicht werden, während die Verwendung lediglich von Poly(ethoxysiloxan) zu "striations" führt. Die beschriebene Lösung wird einer Vakuumbehandlung unterzogen, um Reste von Säure, speziell von Salzsäure, die als Katalysator für die Hydrolyse eingesetzt wird, zu entfernen. Um den Verdunstungsverlust gering zu halten, werden Lösungsmittel mit einem Siedepunkt von größer als 110° C (1 bar) beansprucht. Ohne Entfernen der Säure durch Vakuumbehandlung gelieren die Lösungen innerhalb von 30 Tagen.

Eine Beschichtungslösung auf der Basis von Poly(organosiloxan) wird in der EP-A 167,854 beschrieben. Da die Poly(organosiloxan)-schicht nicht ausreichend vernetzbar ist, bleibt sie in organischen Lösungsmitteln löslich und muß, um die erforderliche Lösungsmittelresistenz zu erreichen, in der Regel in einem Sauerstoffplasma oberflächlich zu $SiO_2$ umgesetzt werden. Andernfalls besteht die Gefahr der Bildung undefinierter Mischschichten, wenn auf die ungehärtete Schicht Photoresists aufgeschleudert werden.

In der DE-A 32 47 173 wird eine stabile Dotierlösung beschrieben, bei der die glasbildende Komponente durch Reaktion von Tetraethylorthosilikat mit einem sauren Dotierstoff in Gegenwart einer katalytisch wirksamen Menge einer starken Mineralsäure oder einer Lewis-Säure in einem wasserfreien Lösungsmittel, bevorzugt wasserfreies Ethanol oder Propanol, entsteht. Das zur Hydrolyse des Tetraethylorthosilikats erforderliche Wasser muß in einer Menge, die kleiner ist als die stöchiometrische Menge, zugesetzt werden, da sonst das Material geliert und sich außerdem ein Niederschlag bildet. Der Zutritt von weiterem, atmosphärischem Wasser muß deshalb aufwendig verhindert werden. Beispiele von dotiermittelfreien Beschichtungslösungen werden nicht genannt.

Eine Beschichtungslösung, die keine Dotierstoffe enthält, wird in der DE-A-35 37 626 beschrieben. Sie besteht aus einer Mischung aus einem Tetraalkylorthosilikat, einem Vinyltrialkoxysilan bzw. Vinyltriacyloxysilan und/oder einem $\gamma$-Glycidoxypropyltrialkoxysilan in einem Lösungsmittel aus einem niederen aliphatischen Alkohol und Wasser, dem gegebenenfalls eine katalytische Menge einer Mineralsäure zugesetzt ist.

Die aus dieser Lösung erzeugten Schichten enthalten nicht hydrolisierbare organische Reste, so daß diese Schichten von organischen Lösungsmitteln angelöst werden, wenn die Trocknungstemperatur zu niedrig ist. Werden derartige Schichten in Mehrschichtsystemen eingesetzt, so muß zum Plasmaätzen dieser Schicht ein sauerstoffhaltiges Plasma verwendet werden, um die organischen Reste zu entfernen. Dabei werden auch die darüberliegenden Photoresistschichten angegriffen, so daß keine dimensionsgetreuen Strukturübertragungen möglich sind. Angaben zur Lagerstabilität der Beschichtungslösung und/oder zur Gleichmäßigkeit der aufgeschleuderten resultierenden Schicht werden nicht gemacht.

Es war deshalb die Aufgabe der Erfindung, eine Beschichtungslösung zur Erzeugung glasartiger Schichten auf einem Substrat bereitzustellen, wobei die Lösung einfach und unter geringstem technischen Aufwand herzustellen ist, eine hohe Lagerstabilität zeigt sowie die resultierende aufgeschleuderte und getrocknete Schicht im besonderen Maße eben ist, d.h. keine "striations" aufweist.

Die Aufgabe wird dadurch gelöst, daß eine Beschichtungslösung zur Erzeugung von glasartigen Schichten auf einem Substrat, die im wesentlichen einen Kieselsäureester, einen Wasser enthaltenden aliphatischen Alkohol als Lösungsmittel und eine Säure in katalytisch wirksamer Menge enthält, dadurch gekennzeichnet ist, daß der Alkohol mindestens 4 Kohlenstoffatome enthält und die Säure einen $pK_s$-Wert

von kleiner als 3 aufweist.

Durch die erfindungsgemäßen Beschichtungslösungen werden die oben beschriebenen Nachteile vermieden. Gleichzeitig weisen sie folgende zusätzlichen Vorteile auf:

1) Die Lösungen sind auch bei höheren Temperaturen über längere Zeit lagerstabil, d.h. es wird eine Zunahme der Lösungsviskosität lediglich von maximal 7%, bevorzugt nicht mehr als 3 %, über eine Lagerzeit von 25 Tagen bei + 50° C gemessen, ohne daß ein Gelieren und eine Präzipitätbildung festzustellen ist.

2) Die Viskositätsstabilität bleibt auch bei weiterem Wasserzusatz über den stöchiometrischen Hydrolysebedarf hinaus im wesentlichen erhalten; Zutritt von Luftfeuchtigkeit beeinträchtigt daher die Lagerstabilität in nur vernachlässigbar geringen Ausmaßen.

3) Die Lösungen lassen sich in einfacher Weise durch Mischen der Einzelkomponenten herstellen; eine spezielle Aufreinigung der Lösung, z.B. um unerwünschte Reste von Säure, beispielsweise durch Vakuumbehandlung, zu entfernen, ist nicht erforderlich.

4) Die durch Aufschleudern der Beschichtungslösung resultierenden glasartigen Schichten sind nach dem Aushärten, in der Regel durch Erhitzen auf 150 bis 200° C für eine bis fünf Minuten auf einer Hotplate, beständig gegen organische Lösungsmittel, insbesondere gegen Lösungsmittel von Photoresists, wie beispielsweise Ethylenglykolmethyletheracetat oder Propylenglykolmethyletheracetat.

5) Die ausgehärteten glasartigen Schichten zeigen eine hohe Gleichmäßigkeit, so daß bei Beleuchten der Schichten mit monochromatischem Licht keine "striations" erkennbar sind.

Als "striations" werden Unregelmäßigkeiten in der Oberfläche von Schichten bezeichnet, die durch Aufschleudern von Beschichtungslösungen auf geeignete Substrate gebildet werden können. Sie lassen sich teilweise mit bloßem Auge, mit Hilfe mechanischer Schichtdickenmeßgeräte als Oberflächenrauhigkeiten (Schichtdickendifferenz zwischen Schichtdickenmaxima und -minima etwa 5 bis 200 nm), als auch mit Hilfe eines mit einem Interferenzfilter ausgestatteten Mikroskops feststellen (ungleichmäßige Intensitätsverteilung des reflektierenden Auflichts, wobei Schichten, die im Auflicht ein homogenes Erscheinungsbild zeigen, als frei von "striations" bezeichnet werden, d.h. eine Schichtdickendifferenz von kleiner als 5 nm aufweisen).

Das Phänomen der Bildung von "striations" wird z.B. in "The influence of striations in AZ 1350 H photoresist films on the generation of small geometries, colloque international sur la microlithographie, Paris 21 - 24 juin 77 (Imprimerie E. M. F. 887-85-93)" von H. Binder, R. Sigusch und D. Widmann diskutiert.

Demzufolge können "striations" durch Dickenunterschiede in der Schicht oder durch optische Dichteunterschiede infolge inhomogener Zusammensetzung der Schicht hervorgerufen werden. Diese Dickenunterschiede wiederum können dadurch entstehen, daß beim Aufschleudern der Lösung auf das Substrat das leichtflüchtige Lösungsmittel verdampft, die Schichtoberfläche daher sehr schnell verhärtet, während gleichzeitig durch die Zentrifugalkraft die schwer flüchtigen Anteile nach außen getrieben werden. Ungleichmäßigkeiten der Schichtdicke sind die unmittelbare Folge.

Die erfindungsgemäße Beschichtungslösung zur Erzeugung von glasartigen Schichten auf einem Substrat, enthält im wesentlichen einen oligomeren oder polymeren Kieselsäureester, einen aliphatischen Alkohol als Lösemittel, eine Säure in katalytisch wirksamer Menge und Wasser, und ist dadurch gekennzeichnet, daß der oligomere oder polymere Kieselsäureester aus Tetraalkoxysilanen der allgemeinen Formel

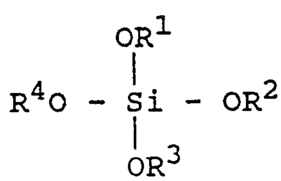

worin $R^1$ bis $R^4$ gleiche oder verschiedene $(C_1$-$C_5)$Alkylgruppen, die ihrerseits mit $(C_1$-$C_5)$-Alkoxygruppen substituiert sein können, bezeichnen, durch partielle Hydrolyse und nachfolgende, unter Abspaltung von Wasser verlaufende Kondensation hergestellt ist,
daß der Alkohol ein Alkanol oder ein Gemisch von Alkanolen mit mindestens 4 Kohlenstoffatomen und gegebenenfalls einem oder mehreren etherartig gebundenen zusätzlichen Sauerstoffatom(en) ist,
und daß die Säure einen $pK_s$-Wert von weniger als +3 besitzt.

Erfindungsgemäß sind als hydrolysierbare Kieselsäureester in den Beschichtungslösungen geeignet:
einfache Tetraalkoxysilane,
wie Tetramethoxysilan

Tetraethoxysilan
Tetrapropoxysilan
Tetrabutoxysilan sowie höhere und gemischte Vertreter,
einfache Tetra(alkoxyalkoxy)silane,
wie Tetra(methoxyethoxy)silan,
Tetra(ethoxyethoxy)silan,
Tetra(methoxypropoxy)silan etc. sowie höhere und gemischte Verbindungen.

Geeignet sind auch Mischungen innerhalb einer Gruppe von Substanzen oder auch von Substanzen mehrerer Gruppen.

Insbesondere werden einfache und/oder gemischte Tetraalkoxysilane bzw. Tetra(alkoxyalkoxy)silane verwendet, deren Alkoxygruppen jeweils 1 bis 5 Kohlenstoffatome aufweisen.

Besonders bevorzugt sind allerdings vorhydrolysierte einfache und gemischte Tetraalkoxysilane, in denen ein Teil der Alkoxygruppen bzw. Alkoxyalkoxygruppen durch Ausbildung von Siloxan-Gruppen sowie durch Hydroxy-Gruppen ersetzt werden. Die Vorhydrolyse der Polyalkoxysiloxane bzw. Poly(alkoxyalkoxy)-siloxane kann soweit fortschreiten, daß das mittlere Molekulargewicht einer Monomereinheit der Polysiloxankette bis auf den Wert von 120 g/mol abnehmen kann.

Der Gehalt der Kieselsäureester in der Schicht kann -je nach gewünschter Viskosität der Beschichtungslösung - 2 bis 50 Gew.-%, bevorzugt 5 bis 25 Gew.-%, bezogen auf das Gesamtgewicht der Beschichtungslösung, betragen.

Als Lösungsmittel sind aliphatische Alkohole mit mindestens 4 Kohlenstoffatomen geeignet. Neben einwertigen, nicht veretherten Alkoholen zählen hierzu auch mehrwertige Alkohole, insbesondere zweiwertige, die mit einwertigen Alkoholen teilverethert sind und mindestens eine Hydroxygruppe unverethert enthalten. Mitumfaßt sind auch oligomer veretherte Alkohole, insbesondere Bi- und Trimere der zweiwertigen, die ebenso durch einwertige Alkohole am Kettenende teilverethert sind, wobei in der bevorzugten Ausführungsform eine endständige Hydroxylgruppe unverethert bleibt.

Besonders bevorzugt werden die zu Oligomeren veretherten zweiwertigen Alkohole durch Alkohole identischer Kohlenstoffzahl gebildet. Die einwertigen Alkohole, die zur Veretherung der endständigen Hydroxylgruppen mehrwertiger und oligomerer Alkohole herangezogen werden, enthalten bevorzugt 1 oder 2 Kohlenstoffatome.

Die Anzahl der Kohlenstoffatome im Alkohol wird bei den oligomeren Alkoholen durch Summierung der Kohlenstoffatome der mehrwertigen Alkohole in der durch Sauerstoffatome verbrückten Kette bestimmt.

Als Beispiele von einwertigen Alkoholen sind zu nennen: 1-Butanol, 2-Butanol, 2-Methyl-1-propanol, 2-Methyl-2-propanol und 1-Pentanol.

Als mehrwertige und oligomere Alkohole werden genannt: Ethylenglykolmonoethylether, Diethylenglykolmonoethylether, Triethylenglykolmonoethylether, Propylenglykolmonomethylether, Dipropylenglykolmonomethylether und Dipropylenglykolmonoethylether. Ebenso geeignet sind Gemische dieser Alkohole untereinander bzw. mit anderen Lösungsmitteln, die sich in dem Alkohol bzw. Alkoholgemisch lösen und eine Beschichtungslösung ergeben, die als glasartige Schicht keine "striations" aufweist. Der Anteil des Alkohols bzw. des Alkoholgemisches beträgt mindestens 50 Gew.-%, bezogen auf das Gesamtgewicht des Lösungsmittels.

Besonders bevorzugt sind Lösungsmittelgemische, in denen als Alkoholkomponente 1-Butanol, 2-Methyl-1-propanol oder 1-Pentanol enthalten sind. Neben dem Kieselsäureester und dem Lösungsmittel bzw. -gemisch enthält die Beschichtungslösung Wasser in einer Menge, die 90 bis 200 Gew.-%, bevorzugt 100 bis 150 Gew.-% derjenigen Wassermenge entspricht, die zur vollständigen Hydrolyse des Kieselsäureesters erforderlich wäre.

Die zur Hydrolyse des Kieselsäureesters notwendige Säure wird in katalytischer Menge von 0,01 bis 5 Gew.-%, bevorzugt 0,05 bis 1 Gew.-%, bezogen auf die Beschichtungslösung eingesetzt. Es sind alle Säuren geeignet, deren $pK_s$-Werte kleiner als +3 sind, in der bevorzugten Ausführungsform von +2 bis -6 reichen.

Besonders geeignet hierunter sind Perchlorsäure, Salzsäure, Schwefelsäure, Salpetersäure, Trifluoressigsäure, Oxalsäure und Malonsäure, ebenso polymere Säuren wie Polystyrolsulfonsäuren u.ä.; besonders bevorzugt sind organische Säuren.

Daneben können die Beschichtungslösungen noch Hilfsstoffe wie Haftvermittler, oberflächenaktive Substanzen und Farbstoffe in üblichen Mengen enthalten.

Das erfindungsgemäße Verfahren zur Herstellung einer "striation"-freien Beschichtung auf einem Substrat ist dadurch gekennzeichnet, daß eine homogene Mischung aus dem Kieselsäureester, dem Lösungsmittel, dem Wasser und der katalytisch wirksamen Säure hergestellt wird, die Mischung bei Temperaturen von 0 bis 120° C, bevorzugt von 20 bis 80° C, polykondensiert wird und die Beschichtungslösung anschließend auf einem Substrat aufgebracht wird.

Nach Tempern der entstandenen glasartigen Schichten bei 150 bis 200° C enthält die Schicht nur noch vernachlässigbare kleine Mengen an organischen Substanzen und Nebenprodukten. Die Schichten lassen sich daher in exakter und vollständiger Weise mit fluorhaltigen Ätzgasen im Plasmaätzverfahren entfernen.

Die glasartigen Schichten weisen eine Schichtdicke im Bereich von 20 nm bis 5µm, bevorzugt von 50 nm bis 2µm auf.

Auf die glasartigen Schichten können mit üblichen Methoden Photoresistschichten aufgebracht werden, wobei die glasartige Schicht nach deren Aushärtung gegen die in dem Photoresist enthaltenen Lösungsmittel resistent ist.

Als Substrate für die Beschichtung mit der erfindungsgemäßen Beschichtungslösung können alle Metall-, Metalloxid- oder Polymerschichten Anwendung finden. Insbesondere sind Halbleitersubstrate und Flüssigkristalldisplays zu nennen.

Die in den folgenden Beispielen hergestellten Beschichtungslösungen sind auch nach einer Lagerzeit von 25 Tagen bei 50 °C stabil. Die aufgeschleuderten Schichten weisen keine "striations" auf.

Beispiele 1 bis 9

Zu 42,0 g getrocknetem und destilliertem n-Butanol wurden 8,0 g Poly(ethoxysiloxan) mit einem Molekulargewicht der Monomereinheiten von durchschnittlich M = 120,1 g/mol gegeben und eine homogene Mischung hergestellt. Anschließend wurden 1,16 g Wasser und eine katalytisch wirksame Säuremenge von etwa $1,2 \times 10^{-3}$ mol hinzugefügt. Die Reaktionszeit betrug 72 h bei 50° C.

Die Lösungen wurden bei +50° C 25 Tage gelagert und der Viskositätsanstieg in dieser Zeit gemessen. Die Ergebnisse sind in Tabelle 1 wiedergegeben.

Tabelle 1

| Beispiel Nr. | Säure | $pK_S$-Wert | Viskositätsanstieg (%) |
|---|---|---|---|
| 1 | Perchlorsäure | - 10 | + 7,3 |
| 2 | Salzsäure | - 6 | + 3,8 |
| 3 | Schwefelsäure | - 3 | + 5,7 |
| 4 | Salpetersäure | - 1,32 | + 2,6 |
| 5 | Trifluoressigsäure | + 0,23 | + 0,2 |
| 6 | Oxalsäure | + 1,24 | + 6,5 |
| 7 | Malonsäure | + 2,79 | + 5,5 |
| 8 | Weinsäure | + 3,01 | geliert |
| 9 | Essigsäure | + 4,75 | geliert |

Die Ergebnisse zeigen, daß der $pK_s$-Wert der eingesetzten Säuren einen deutlichen Einfluß auf die Stabilität der Poly(ethoxysiloxan)-Lösungen hat. Schwache Säuren mit einem $pK_s$-Wert > 3,0 bewirken das unerwünschte Gelieren, während Säuren mit einem $pK_s$-Wert von < 3,0 zu stabilen Lösungen führen.

Beispiele 10 bis 17

Zu 42,0 g des in Tabelle 2 aufgeführten Lösungsmittels wurden 8,0 g Poly(ethoxysiloxan) mit einem Molekulargewicht der Monomereinheiten von durchschnittlich M = 120,1 g/mol gegeben und eine homogene Mischung hergestellt. Es wurden 1,16 g Wasser und eine katalytisch wirksame Säuremenge von etwa $1,2 \times 10^{-3}$ mol zugegeben und diese innerhalb 72 h bei 50 °C zur Reaktion gebracht.

Der Viskositätsanstieg über einen Zeitraum von 25 Tagen bei +50° C in Abhängigkeit von dem Lösungsmittel ist in Tabelle 2 wiedergegeben.

Tabelle 2

| Beispiel Nr. | Lösungsmittel | Viskositäts-anstieg (%) |
|---|---|---|
| 10 | Methanol | 14,5 |
| 11 | Ethanol | 1,0 |
| 12 | Ethanol (66 Gew.-Teile) Ethylacetat (34 Gew.-Teile) | 4,5 |
| 13 | 2-Propanol | 0,3 |
| 14 | 1-Butanol | 0,2 |
| 15 | 2-Methyl-1-propanol | 0,4 |
| 16 | 1-Pentanol | 2,2 |

Beispiele 17 bis 23

Die in den Beispielen 10 bis 16 genannten Lösungen wurden auf Siliciumwafer mit 3.000 Umdrehungen pro Minute aufgeschleudert, bei 200° C 30 Minuten lang getrocknet und die Oberflächenqualität beurteilt. Geprüft wurden die Schichten auf "striations" und auf Fehlstellen. Um Fehlstellen durch Staubpartikel auszuschließen, wurden die Lösungen durch ein Filter mit einem Porendurchmesser von etwa 0,2 µm feinstfiltriert. Die Ergebnisse sind in Tabelle 3 zusammengefaßt.

Tabelle 3

| Beispiel Nr. | Lösungsmittel | Schichtqualität |
|---|---|---|
| 17 | Methanol | starke striations |
| 18 | Ethanol | striations |
| 19 | Ethanol (66 Gew.-Teile)/Ethylacetat (34 Gew.-Teile) | striations |
| 20 | 2-Propanol | striations |
| 21 | 1-Butanol | keine striations, keine Defekte |
| 22 | 2-Methyl-1-propanol | keine striations, keine Defekte |
| 23 | 1-Pentanol | keine striations, keine Defekte |

Beispiele 24 bis 28

Zu 84,0 g getrocknetem und destilliertem n-Butanol wurden 16,0 g Poly(ethoxysiloxan) mit einem Molekulargewicht der Monomereinheiten von durchschnittlich M = 120,1 g/mol gegeben und eine homogene Mischung hergestellt. Anschließend wurden die in Tabelle 4 angegebenen Wassermengen und eine katalytisch wirksame Säuremenge von etwa 1,2 x $10^{-3}$ mol hinzugefügt. Die Reaktionszeit betrug 72 h bei 50 °C. Die in Klammern angegebenen Prozentwerte beziehen sich auf die notwendige Wassermenge (100 % = vollständige Hydrolyse).

Die Lösungen wurden bei +50° C 25 Tage gelagert und die Viskositätsänderung in dieser Zeit gemessen. Die Ergebnisse sind in Tabelle 4 wiedergegeben.

Tabelle 4

| Beispiel Nr. | Zugesetzte Menge an Wasser | Viskositätsänderung (%) |
|---|---|---|
| 24 | 2,07 g (107 %) | 5,9 |
| 25 | 2,30 g (118 %) | 0,2 |
| 26 | 2,53 g (130 %) | 1,7 |
| 27 | 2,76 g (142 %) | 1,7 |
| 28 | 3,45 g (178 %) | 2,6 |

Es ist erkennbar, daß die Viskosität der Lösung in vernachlässigbar geringem Umfang von der zugesetzten Wassermenge abhängt.

Beispiele 29 bis 32

Zu 42,0 g getrocknetem und destilliertem 1-Pentanol wurden 8,0 g Poly(ethoxysiloxan) mit einem Molekulargewicht der Monomereinheiten von durchschnittlich M = 120,1 g/mol gegeben und eine homogene Mischung hergestellt. Anschließend wurden die in Tabelle 5 angegebenen Mengen an Trifluoressigsäure und eine überstöchiometrische Menge an Wasser von 118 % zugegeben. Die Lösungen wurden bei +50° C 25 Tage gelagert und die Viskositätsänderung in dieser Zeit gemessen. Die Ergebnisse sind in Tabelle 5 wiedergegeben.

Tabelle 5

| Beispiel Nr. | Zugesetzte Menge an Trifluoressigsäure | Viskositätsänderung (%) |
|---|---|---|
| 29 | 6,6 x $10^{-3}$ g | + 11,7 |
| 30 | 26,7 x $10^{-3}$ g | + 5,3 |
| 31 | 0,66 g | + 3,3 |
| 32 | 2,67 g | + 12,0 |

**Patentansprüche**

1. Beschichtungslösung zur Erzeugung von glasartigen Schichten auf einem Substrat, die im wesentlichen einen oligomeren oder polymeren Kieselsäureester, einen aliphatischen Alkohol als Lösemittel, eine Säure in katalytisch wirksamer Menge und Wasser enthält, dadurch gekennzeichnet, daß der oligomere oder polymere Kieselsäureester aus Tetraalkoxysilanen der allgemeinen Formel

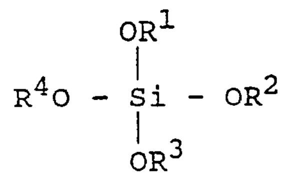

worin $R^1$ bis $R^4$ gleiche oder verschiedene ($C_1$-$C_5$)Alkylgruppen, die ihrerseits mit ($C_1$-$C_5$)-Alkoxygruppen substituiert sein können, bezeichnen, durch partielle Hydrolyse und nachfolgende, unter Abspaltung von Wasser verlaufende Kondensation hergestellt ist,

daß der Alkohol ein Alkanol oder ein Gemisch von Alkanolen mit mindestens 4 Kohlenstoffatomen und gegebenenfalls einem oder mehreren etherartig gebundenen zusätzlichen Sauerstoffatom(en) ist,

und daß die Säure einen $pK_s$-Wert von weniger als +3 besitzt.

2. Beschichtungslösung nach Anspruch 1, dadurch gekennzeichnet, daß der Gehalt an Kieselsäureester 2 bis 50 Gew.-%, insbesondere 5 bis 25 Gew.-%, bezogen auf das Gesamtgewicht der Beschichtungslösung, beträgt.

3. Beschichtungslösung nach Anspruch 1 oder 2, dadurch gekennzeichnet, daß der Alkohol ein $C_4$-oder $C_5$-Alkanol ist.

4. Beschichtungslösung nach Anspruch 1, dadurch gekennzeichnet, daß der $pK_s$-Wert der Säure im Bereich von +2 bis -6 liegt.

5. Beschichtungslösung nach den Ansprüchen 1 oder 4, dadurch gekennzeichnet, daß die Säure eine organische Säure ist.

6. Beschichtungslösung nach Anspruch 1, dadurch gekennzeichnet, daß Wasser in einer Menge, die 90 bis 200 % derjenigen Wassermenge entspricht, die zur vollständigen Hydrolyse des Kieselsäureesters erforderlich ist, eingesetzt wird.

7. Verfahren zur Herstellung einer "striation"-freien Beschichtung auf einem Substrat mit einer Beschichtungslösung nach einem der Ansprüche 1 bis 6, dadurch gekennzeichnet, daß eine homogene Mischung aus dem Kieselsäureester, dem Lösemittel, dem Wasser und der Säure hergestellt, der Kieselsäureester bei einer Temperatur von 0 bis 120 °C, bevorzugt von 20 bis 80 °C, polykondensiert und die Beschichtungslösung anschließend auf ein Substrat aufgebracht und getempert wird.

8. Verfahren zur Herstellung einer Beschichtung nach Anspruch 7, dadurch gekennzeichnet, daß auf die getemperte glasartige Schicht eine Photoresistschicht in an sich bekannter Weise aufgebracht wird.

9. Verfahren nach einem der Ansprüche 7 oder 8, dadurch gekennzeichnet, daß das Substrat eine Metall-, Metalloxid- oder eine Polymerschicht, insbesondere ein Halbleitersubstrat oder ein Flüssigkristalldisplay, ist.

10. Verfahren nach Anspruch 7, dadurch gekennzeichnet, daß die Beschichtung nach dem Tempern eine Dicke von 20 nm bis 5,0 µm, insbesondere 50 nm bis 2,0 µm, aufweist.

## Claims

1. A coating solution for producing glassy layers on a substrate which contains essentially an oligomeric

or polymeric silicic acid ester, an aliphatic alcohol as solvent, an acid in a catalytically active quantity and water, wherein the oligomeric or polymeric silicic acid ester has been prepared from tetraalkoxysilanes of the general formula

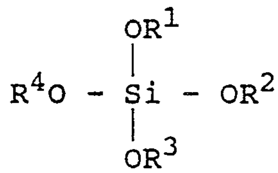

in which $R^1$ to $R^4$ denote the same or different $(C_1$-$C_5)$alkyl groups, which themselves may be substituted by $(C_1$-$C_5)$alkoxy groups, by partial hydrolysis and subsequent condensation taking place with elimination of water, wherein the alcohol is an alkanol or a mixture of alkanols containing at least 4 carbon atoms and optionally one or more additional oxygen atom(s), bonded by an ether-like bond, and wherein the acid has a $pK_a$ of less than +3.

**2.** A coating solution as claimed in claim 1, wherein the content of silicic acid ester is 2 to 50 % by weight, in particular 5 to 25 % by weight, based on the total weight of the coating solution.

**3.** A coating solution as claimed in claim 1 or 2, wherein the alcohol is an $C_4$- or $C_5$-alkanol.

**4.** A coating solution as claimed in claim 1, wherein the $pK_a$ of the acid is in the range from +2 to -6.

**5.** A coating solution as claimed in claim 1 or 4, wherein the acid is an organic acid.

**6.** A coating solution as claimed in claim 1, wherein water is used in a quantity corresponding to 90 to 200 % of the quantity of water required for the complete hydrolysis of the silicic acid ester.

**7.** A process for producing a "striation"-free coating on a substrate with a coating solution as claimed in any of claims 1 to 6, wherein a homogeneous mixture is prepared from the silicic acid ester, the solvent, the water and the acid, the silicic acid ester is polycondensed at a temperature from 0 to 120 °C, preferably from 20 to 80 °C, and the coating solution is subsequently deposited on a substrate and heat-treated.

**8.** A process for producing a coating as claimed in claim 7, wherein a photoresist layer is deposited in a manner known per se on the heat-treated glassy layer.

**9.** A process as claimed in any of the claims 7 or 8, wherein the substrate is a metal, metal oxide or a polymer layer, in particular a semiconductor substrate or a liquid crystal display.

**10.** A process as claimed in claim 7, wherein the coating has a thickness of 20 nm to 5.0 $\mu$m, in particular 50 nm to 2.0 $\mu$m, after heat-treatment.

## Revendications

**1.** Solution de revêtement pour la production de couches vitreuses sur un support, contenant essentiellement un ester d'acide silicique oligomère ou polymère, un alcool aliphatique en tant que solvant, un acide en quantité catalytiquement efficace et de l'eau, caractérisée en ce que l'ester d'acide silicique oligomère ou polymère est préparé à partir de tétraalcoxysilanes de formule générale

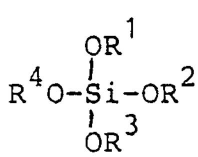

dans laquelle $R^1$ et $R^4$ représentent des groupes alkyle en $C_1$-$C_5$ identiques ou différents, qui pour leur part peuvent être substitués par des groupes alcoxy en $C_1$-$C_5$, par hydrolyse partielle et condensation subséquente se déroulant avec élimination d'eau,
en ce que l'alcool est un alcanol ou un mélange d'alcanols contenant au moins 4 atomes de carbone et éventuellement un ou plusieurs atome(s) d'oxygène supplémentaire(s) lié(s) par une liaison de type éther,
et en ce que l'acide a un $pK_a$ inférieur à +3.

**2.** Solution de revêtement selon la revendication 1, caractérisée en ce que la teneur en ester d'acide silicique va de 2 à 50 % en poids, en particulier de 5 à 25 % en poids, par rapport au poids total de la solution de revêtement.

**3.** Solution de revêtement selon la revendication 1 ou 2, caractérisée en ce que l'alcool est un alcanol en $C_4$ ou $C_5$.

**4.** Solution de revêtement selon la revendication 1, caractérisée en ce que le $pK_a$ de l'acide se situe dans la plage de +2 à -6.

**5.** Solution de revêtement selon la revendication 1 ou 4, caractérisée en ce que l'acide est un acide organique.

**6.** Solution de revêtement selon la revendication 1, caractérisée en ce que l'eau est utilisée en une quantité qui correspond à 90-200 % de la quantité d'eau qui est requise pour l'hydrolyse totale de l'ester d'acide silicique.

**7.** Procédé pour la production d'un revêtement exempt de "striations" sur un support, à l'aide d'une solution de revêtement selon l'une des revendications 1 à 6, caractérisé en ce que l'on prépare un mélange homogène à partir de l'ester d'acide silicique, du solvant, de l'eau et de l'acide, on soumet l'ester d'acide silicique à une polycondensation à une température de 0 à 120 °C, de préférence de 20 à 80 °C, et on applique ensuite sur un support la solution de revêtement et on la soumet à un traitement thermique.

**8.** Procédé pour la production d'un revêtement selon la revendication 7, caractérisé en ce que l'on applique d'une façon connue en soi une couche de photoresist sur la couche vitreuse traitée thermiquement.

**9.** Procédé selon la revendication 7 ou 8, caractérisé en ce que le support est une couche de métal, d'oxyde métallique ou de polymère, en particulier un support de semiconducteur ou un affichage à cristaux liquides.

**10.** Procédé selon la revendication 7, caractérisé en ce que le revêtement présente après le traitement thermique une épaisseur de 20 nm à 5,0 $\mu$m, en particulier de 50 nm à 2,0 $\mu$m.